# EUROPÄISCHE PATENTSCHRIFT

(11) **EP 3 298 631 B1**
(45) Veröffentlichungstag und Bekanntmachung des Hinweises auf die Patenterteilung: **04.03.2020**
(21) Anmeldenummer: 16729749.8
(22) Anmeldetag: 18.05.2016
(51) Int. Cl.: H01L 31/048, H01L 31/049

(54) **PHOTOVOLTAIKELEMENT**
PHOTOVOLTAIC ELEMENT
ÉLÉMENT PHOTOVOLTAÏQUE

(30) Priorität: 20.05.2015 AT 3202015
(43) Veröffentlichungstag der Anmeldung: 28.03.2018
(73) Patentinhaber: Lenzing Plastics GmbH & Co KG, 4860 Lenzing (AT)
(72) Erfinder: BRANDSTÄTTER, Andreas, 4851 Gampern (AT); GRIESHOFER, Hubert, 4813 Altmünster (AT)
(74) Vertreter: Fabian, Ferdinand
(86) Internationale Anmeldenummer: PCT/AT2016/050146
(87) Internationale Veröffentlichungsnummer: WO 2016/183604

(56) Entgegenhaltungen:
- EP-A1- 2 822 043
- EP-A1- 2 863 443
- WO-A2-2007/149969
- DE-A1-102012 008 218
- KR-A- 20130 083 737
- US-A- 4 636 578
- US-A- 6 114 046
- US-A1- 2012 024 348

## Beschreibung

Die Erfindung betrifft ein Photovoltaikelement umfassend eine oberes Einbettfolienmaterial und eine unteres Einbettfolienmaterial, wobei zwischen dem oberen und dem unteren Einbettfolienmaterial Photovoltaikzellen eingebettet sind, sowie ein Rückseitenfolienmaterial, das in Einbaulage des Photovoltaikelementes unterhalb des unteren Einbettfolienmaterials angeordnet ist.

Ein handelsübliches Photovoltaikmodul besteht an der Vorderseite (der der Sonne zugewandten Seite) aus einer Glasscheibe, insbesondere ein Einscheiben-Sicherheits-Glas (ESG), darunter einer transparenten Einbettfolie, um die Solar-Zellen und deren elektrische Verdrahtung (Lötbändchen) zum Glas hin einzubetten, unterhalb der Elektronik mit den Solar-Zellen befindet sich typischerweise wieder die gleiche Einbettfolie und den rückseitigen Abschluss bildet ein Folien-laminat, die sogenannte Rückseitenfolie, die beispielsweise aus einem PVF-PET-PVF-Laminat (Polyvinylfluorid-Polyethylenterephthalat-Polyvinylfluorid-Laminat) gebildet ist. Die Einbettfolien sind typischerweise aus EVA (Polyethyl-en-Vinylacetat) aufgebaut. Alle Schichten werden beim Zusammenbau der Module übereinandergelegt und miteinander thermisch laminiert. Das EVA wird chemisch vernetzt. Beim Laminieren bildet sich aus der bis dahin milchigen EVA-Folie eine klare, dreidimensional vernetzte und nicht mehr aufschmelzbare Kunststoffschicht, in der die Solar-Zellen eingebettet sind und die fest mit der Glasscheibe und der Rückseitenfolie verbunden ist. Ein derartiger Aufbau ist beispielsweise aus "http://www.solarfassade.info/de/grundlagen/komponenten/pvmodule.php" ersichtlich. Ein derartiger Aufbau hat im Wesentlichen zwei Nachteile, die aus dem Einsatz der genannten Werkstoffe resultieren. Einerseits setzt das EVA aufgrund der Sonneneinstrahlung Essigsäure frei. Da Essigsäure bekanntlich korrosiv auf die Solar-Zellen und deren Verdrahtung wirkt, muss es aus dem Photovoltaikmodul abgeführt werden. Dies bedingt wiederum, dass das Laminat an der Rückseite diffusionsoffen sein muss, da die Essigsäure nicht über die vordere Glasscheibe entweichen kann. Die Diffusionsfähigkeit der Rückseitenfolie verhindert die wetterdichte Ausgestaltung des Photovoltaikmoduls. Zudem können die Vernetzungsmittel zum Vernetzen des EVA Peroxide bilden, die zu einer vorzeitigen Alterung führen. EP 2822043 A1 beschreibt ein Einkapselungsfolienmatreial zum Einkapseln einer Solarbatterie nach dem Stand der Technik.

Andererseits wurde die Steifigkeit des Photovoltaikmoduls bis jetzt hauptsächlich über die Glasdicke gesteuert. Der Rückseitenfolie wurde hinsichtlich Steifigkeit kaum Beachtung geschenkt. Aufgrund unterschiedlicher Wärmedehnungen zwischen dem Glas auf der Vorderseite und der Rückseitenfolie können in dem Laminat entsprechende Spannungen entstehen, die für den dauerhaften Verbund des Laminats schädlich sein können. Der Gegenstand der vorliegenden Erfindung ist in Anspruch 1 definiert.

Der vorliegenden Erfindung liegt die Aufgabe zugrunde, ein Photovoltaikelement hinsichtlich seiner Dauerbeständigkeit zu verbessern.

Diese Aufgabe wird bei dem eingangs genannten Photovoltaikelement dadurch gelöst, dass das Rückseitenfolienmaterial durch eine Verbundfolie gebildet ist, die zumindest eine Kunststoffschicht und zumindest eine Faserverstärkung umfasst dass die Verbundfolie des Rückseitenfolienmaterials zumindest eine Barriereschicht enthält, die durch zumindest eine Metallfolie gebildet ist.

Durch die Faserverstärkung des Rückseitenfolienmaterials kann eine verbesserte Steifigkeit und Festigkeit speziell bei Temperaturen über Raumtemperatur bis hin zur Laminationstemperatur erreicht werden. Durch die verbesserte mechanische Festigkeit gegenüber Beschädigungen einerseits, aber auch durch das steifere Rückseitenfolienmaterial kann die Glasdicke und somit das Gesamtgewicht des Photovoltaikelementes verringert werden. Es hat sich zudem gezeigt, dass dieses Rückseitenfolienmaterial eine geringere Kriechneigung als Rückseitenfolien von handelsüblichen Photovoltaikmodulen aufweist. Weiter weist das Rückseitenfolienmaterial eine reduzierte, an die Frontverglasung angepasste, Wärmedehnung auf, was bei Temperaturänderungen zu weniger Spannungen im Modulaufbau führt. Für Spannungen durch unterschiedliche Wärmeausdehnungen sind vor allem die Abdeckung aus Glas und das Rückseitenfolienmaterial verantwortlich, da die beiden Einbettfolienmaterialien für die Elektronik in der Regel eine elastische Einlage gewährleisten und über diese Einbettfolienmaterialien unterschiedliche Ausdehnungen aufgenommen werden können. Somit ist es von Vorteil, möglichst gleiche Wärmeausdehnungskoeffizienten bei den beiden steifen Randschichten, der Glasabdeckung und des Rückseitenfolienmaterials, zu haben. Mit einer Faserverstärkung der Rückseitenfolie kann der Wärmeausdehnungskoeffizient von Kunststoff verringert und an den Wert von Glas angenähert werden. Somit weist ein Aufbau mit einer faserverstärkten Rückseitenfolie weniger Eigenspannungen und eine geringere Verzugsneigung auf. Zudem kann durch den Einsatz die Verarbeitbarkeit im Laminationsprozess verbessert werden. Durch die Faserverstärkung kann weiter eine Flammwidrigkeit des gesamten Photovoltaikelementes, hier insbesondere auch des Rückseitenfolienmaterials, erreicht werden, wodurch dieses im Brandfalle nicht zusätzlich zur Brand-ausbreitung beiträgt. Flammhemmende Folien in Photovoltaikmodulen bestehen meist aus PVF, was den Nachteil hat, dass es durch das Fluor im Kunststoff im Brandfall zur Bildung toxischer Halogenverbindungen kommt. Durch das Einbettfolienmaterial wiederum kann die Entstehung von Spaltprodukten aus dem Polymer während der Verwendung des Photovoltaikelements vermieden werden. Es kann damit der Aufbau des gesamten Photovoltaikelementes vereinfacht bzw. verbessert werden, indem auf das Ausdiffundieren dieser Spaltprodukte nicht mehr Rücksicht genommen werden muss, sodass das Photovoltaikelement insgesamt gasdichter ausgebildet werden kann. Darüber hinaus kann damit auch der Laminationsprozess an sich vereinfacht werden. Durch die Verwendung eines physikalisch vernetzten Kunststoffes kann die Laminationszeit reduziert werden, da keine chemische Vernetzungsreaktion notwendig ist.

Gemäß einer Ausführungsvariante des Photovoltaikelementes kann vorgesehen sein, dass die Verbundfolie des Rückseitenfolienmaterials zumindest eine erste, außenliegende Kunststoffschicht und zumindest eine zweite, innenliegende Kunststoffschicht aufweist, wobei die zweite, innenliegende Kunststoffschicht weniger stabilisiert ist als die erste, außenliegende Kunststoffschicht. Von Vorteil ist dabei, dass die höher stabilisierte Kunststoffschicht, d.h. die witterungsstabilisierte, äußere, erste Kunststoffschicht mit einer geringeren Schichtdicke am Gesamtverbund eingesetzt werden kann, wodurch entsprechende Kostenvorteile realisiert werden können. Die im Vergleich dazu weniger stabilisierte zweite Kunststoffschicht ist dicker ausgeführt als die erste Kunststoffschicht und gewährleistet die elektrische Isolation.
Es kann weiter vorgesehen sein, dass die Verbundfolie des Rückseitenfolienmaterials zumindest eine Barriereschicht enthält. Es ist damit möglich, das Photovoltaikelement besser vor Witterungseinflüssen, wie insbesondere Wasserdampf-eintritt, zu schützen. Wasserdampf kann zum Beschlag der Innenseite der Glasscheibe und damit zur Verringerung des Wirkungsgrades bis hin zum Versagen der Elektronik führen. Besonders vorteilhaft ist diese Ausgestaltung des Photovoltaikelements im Zusammenspiel mit dem physikalisch vernetzten Kunststoff des Einbettfolienmaterials, da damit keine Spaltprodukte aus dem Einbettmaterial nach außen aus dem Photovoltaikelement abgeführt werden müssen. Es müssen somit keine Kompromisse hinsichtlich Barriereeigenschaften und Durchlässigkeit des Rückseitenfolienmaterials eingegangen werden. Darüber hinaus kann damit das Alterungsverhalten des Photovoltaikelementes verbessert werden.

Gemäß einer Ausführungsvariante dazu ist vorgesehen, dass die Barriereschicht durch zumindest eine Metallfolie, insbesondere eine Aluminiumfolie, gebildet ist. Es kann damit nicht nur die primäre Barrierefunktion zur Verfügung gestellt werden, sondern kann damit zusätzlich das Reflexions-verhalten des Rückseitenfolienmaterials verbessert werden, sodass mehr durch die Einbettfolienmaterialschichten hindurchgetretenes Sonnenlicht in Richtung auf die Photovoltaikzellen reflektiert werden, wodurch die Energieausbeute des Photovoltaikelementes verbessert werden kann. Durch die Verwendung einer Metallfolie kann darüber hinaus eine verbesserte Wärmeleitfähigkeit des Rückseitenfolienmaterials erreicht werden, wodurch HotSpots im Betrieb des Photovoltaikelementes besser verhindert werden können.

Aus den zu dem Einbettfolienmaterial genannten Gründen ist es von Vorteil, wenn die Verbundfolie des Rückseitenfolienmaterials eine Schicht aus einem physikalisch vernetzten Kunststoff aufweist.

Der physikalisch vernetzte Kunststoff des Einbettfolienmaterials und/oder der physikalisch vernetzte Kunststoff des Rückseitenfolienmaterials kann ein Ionomer sein. Es können damit die optischen Eigenschaften, wie Brechungsindex und Transmissionsgrad, im Vergleich zu im Stand der Technik eingesetzten Ethylen-Vinylacetat-Copolymer-Folien über die gesamte Lebensdauer des Photovoltaikelementes erhöht werden.

Bevorzugt ist das Ionomer ein Zink-Ionomer auf Basis Ethylen/ Metacrylsäure-Copolymer. Im Vergleich zu anderen Ionomeren kann damit die Haftung zu Glas-oberflächen oder Polyamid verbessert werden. Andererseits weist dieses Ionomer aber auch gute Fließeigenschaften, eine hohe Schlagzähigkeit und eine geringe Feuchtigkeitsaufnahme auf.

Es kann weiter vorgesehen sein, dass jeweils die einzelnen Schichten des Einbettfolienmaterials und/oder des Rückseitenfolienmaterials mit einem Klebstoff miteinander verbunden sind, wodurch eine hohe Temperaturbeständigkeit und eine dauerhafte, hohe Haftung sowie ein gutes Alterungsverhalten des Einbettfolienmaterials und/oder des Rückseitenfolienmaterials erreicht werden kann.

Zu besseren Anpassung des Wärmeausdehnungsverhaltens des Rückseitenfolienmaterials an jenes der Glasabdeckung an der Vorderseite kann vorgesehen werden, dass die Faserverstärkung zu zumindest 80 Gew.-% aus Glasfasern besteht.

Zudem kann vorgesehen werden, dass die Faserverstärkung durch ein Gewebe gebildet ist, wodurch ebenfalls eine weitere Verbesserung des mechanischen Verhaltens des Rückseitenfolienmaterials erreicht werden kann.

Die aus der Faserverstärkung bestehende Schicht kann ein Flächengewicht zwischen 100 g/m² und 250 g/m² aufweisen. Es kann damit eine nahezu geschlossene Schicht gebildet werden.

Zum besseren Verständnis der Erfindung wird diese anhand der nachfolgenden Figuren näher erläutert.

Es zeigen jeweils in vereinfachter, schematischer Darstellung:
- Fig. 1: einen Ausschnitt aus einem Photovoltaikelement im Querschnitt;
- Fig. 2: die Abhängigkeit des Brechungsindex von der Temperatur von Einbettfolienmaterialen;
- Fig. 3: das Transmissionsspektrum von Einbettfolienmaterialien;
- Fig. 4: das Reflexionsspektrum von Einbettfolienmaterialien;
- Fig. 5: das Alterungsverhalten des Einbettfolienmaterials;
- Fig. 6: das Alterungsverhalten des Rückseitenfolienmaterials;
- Fig. 7: den Spannungs-Dehnungsverlauf verschiedener Rückseitenfolien-materialien;
- Fig. 8: das Schrumpfverhalten verschiedener Rückseitenfolienmaterialien.

Einführend sei festgehalten, dass in den unterschiedlich beschriebenen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und sind diese Lageangaben bei einer Lageänderung sinngemäß auf die neue Lage zu übertragen.

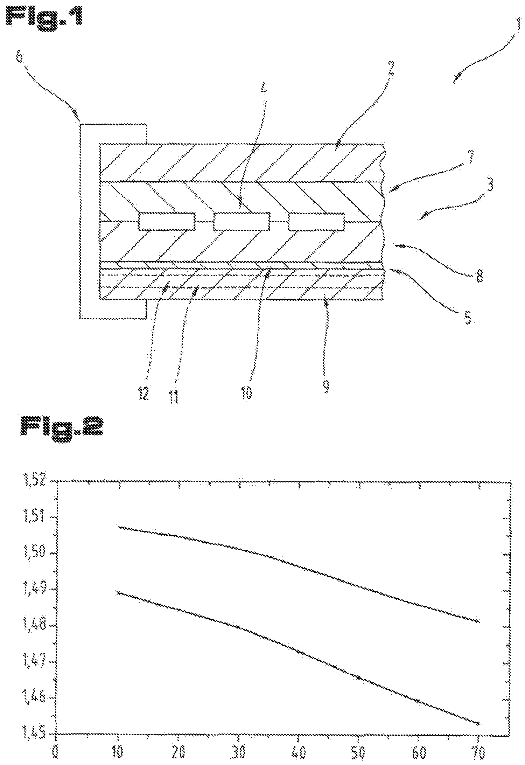

In Fig. 1 ist ein Ausschnitt aus einem Photovoltaikelement 1 im Querschnitt dargestellt. Dieses Photovoltaikelement 1 umfasst bzw. besteht aus einem oberen Abdeckelement 2, einem darunter angeordnetem und mit dem oberen Abdeckelement 2 verbundenen Einbettelement 3, in dem mehrere Photovoltaikelemente 4 eingebettet sind, und einem Rückseitenfolienmaterial 5, das mit dem Einbettelement 3 verbunden und unterhalb von diesem angeordnet ist. Eingefasst kann dieser Schichtaufbau von einem Rahmen 6 werden, der vorzugsweise das obere Abdeckelement 2 und das Rückseitenfolienmaterial 3 überdeckend angeordnet ist.

Das Einbettelement 3 umfasst zumindest ein oberes Einbettfolienmaterial 7 und zumindest ein unteres Einbettfolienmaterial 8 bzw. besteht aus dem oberen und dem unteren Einbettfolienmaterial 7, 8.

Die Photovoltaikzellen 4 und deren in Fig. 1 nicht dargestellte elektrische Kontaktierung bzw. Verdrahtung sind zwischen dem oberen und dem unteren Einbettfolienmaterial 7, 8 angeordnet bzw. eingebettet. Bezüglich weiterer Details zu den Photovoltaikzellen 4 sei auf den einschlägigen Stand der Technik verwiesen.

Gemäß einer ersten bevorzugten Ausführungsvariante des Photovoltaikelementes 1 ist das Rückseitenfolienmaterial 5 durch eine Verbundfolie gebildet, die zumindest eine Kunststoffschicht 9 und zumindest eine Faserverstärkung 10 umfasst. Bei dieser Ausführungsvariante können die beiden Einbettfolienmaterialien 7,8 auch aus dem Stand der Technik entsprechenden Kunststoffen bestehen.

Nach einer weiteren, gegebenenfalls für sich eigenständigen, bevorzugten Ausführungsvariante des Photovoltaikelementes 1 ist vorgesehen, dass zumindest eines der beiden Einbettfolienmaterialien 7, 8, bevorzugt sowohl das obere als auch das untere Einbettfolienmaterial 7, 8, einen physikalisch vernetzten Kunststoff aufweist, insbesondere aus diesem besteht. Dabei können die beiden Einbettfolienmaterialien 7, 8 aus dem gleichen Kunststoff bestehen. Denkbar ist aber auch, dass diese aus unterschiedlichen Kunststoffen bestehen. Bei dieser Aus-führungsvariante kann das Rückseitenfolienmaterial 5 dem Stand der Technik entsprechend ausgebildet sein.

Nach einer anderen, gegebenenfalls für sich eigenständigen, bevorzugten Ausführungsvariante des Photovoltaikelementes 1 ist vorgesehen, dass das Rückseitenfolienmaterial 5 durch die Verbundfolie gebildet ist, die die zumindest eine Kunststoffschicht 9 und die zumindest eine Faserverstärkung 10 umfasst, und dass zumindest eines der beiden Einbettfolienmaterialien 7, 8, bevorzugt sowohl das obere als auch das untere Einbettfolienmaterial 7, 8, einen physikalisch vernetzten Kunststoff aufweist, insbesondere aus diesem besteht.

Die Faserverstärkung 10 ist bevorzugt als eigene Schicht ausgebildet, die zwischen der der Kunststoffschicht 9 und dem unteren Einbettfolienmaterial 8 angeordnet ist. Sollten in der Faserverstärkungsschicht Hohlräume ausgebildet sein, können diese auch mit dem Kunststoff der Kunststoffschicht 9 und/oder des unteren Einbettfolienmaterials 8 zumindest teilweise ausgefüllt sein.

Die Faserverstärkung 10 kann aus Fasern und/oder Fäden gebildet sein, die ausgewählt sind aus einer Gruppe umfassend oder bestehend aus Glasfasern, Aramidfasern, Kohlenstofffasern, Mineralfasern, wie beispielsweise Basaltfasern, Naturfasern, wie z.B. Hanf, Sisal, und Kombinationen daraus.

Bevorzugt werden Glasfasern als Faserverstärkungsschicht eingesetzt. Der Anteil der Glasfasern an der Faserverstärkung 10 kann zumindest 80 Gew.-%, insbesondere zumindest 90 Gew.-% betragen. Bevorzugt bestehen die Fasern und/oder Fäden der Faserverstärkung 10 ausschließlich aus Glasfasern.

Die Fasern und/oder Fäden können in der Faserverstärkung 10 als Gelege, beispielsweise als Vlies, vorliegen. Bevorzugt wird jedoch ein Gewebe oder ein Gestrick aus den Fasern und/oder Fäden. Es ist dabei auch möglich, dass das Gewebe oder Gestrick nur bereichsweise vorliegt und die restlichen Bereiche der Faserverstärkung 10 durch ein Gelege gebildet werden.

Bei Verwendung eines Gewebes sind unterschiedliche Bindungsarten, insbesondere Leinwand-, Köper- oder Atlasbindung, möglich. Bevorzugt wird eine Leinwandbindung eingesetzt.

Das Flächengewicht der Faserverstärkung 10 kann zwischen 10 g/m² und 1000 g/m² betragen. Bevorzugt wird aus voranstehenden Gründen eine Faserverstärkung 10 mit einem Flächengewicht zwischen 100 g/m² und 250 g/m² eingesetzt. Es kann damit eine geschlossene Schicht erzeugt werden, welche eine einheitliche Materialanbindung mit dem Kunststoff des Einbettfolienmaterials 7, 8 ermöglicht. Zudem können damit Eigenschaften der Verbundfolie wie Wärmeausdehnung oder Kriechneigung, beeinflusst werden. Die Steifigkeit der Faserverstärkung 10 geht beispielsweise mit der dritten Potenz ihrer Dicke, d.h. ihres Flächengewichts, in die Gesamtfolienverbundsteifigkeit ein.

Es ist aber auch möglich, ein offenmaschiges Glasgewebe oder Glasgelege mit einem Flächengewischt zwischen 10 g/m² bis 90 g/m² zu verwenden.

Die Faserverstärkung 10 kann als Einzelschicht ausgebildet sein. Es ist aber auch möglich, dass die Faserverstärkung 10 mehrere, gegebenenfalls voneinander getrennte, Einzelschichten aufweist, beispielsweise zwei oder drei, wobei zumindest einzelne der mehreren Einzelschichten zumindest bereichsweise, vorzugsweise zur Gänze, auch aus zum Rest der Einzelschichten unterschiedlichen Fasern und/oder Fäden bestehen können.

Die Kunststoffschicht 9 kann beispielsweise zu zumindest 80 Gew.-%, insbesondere zu zumindest 90 Gew.-%, vorzugsweise zu 100 Gew.-% aus einem Kunststoff bestehen, der ausgewählt ist aus einer Gruppe umfassend oder bestehend aus Polyolefinen, Kunststoffen auf Basis von beispielsweise Polyestern oder Polyamiden.

Es sei an dieser Stelle erwähnt, dass unter einem Kunststoff ein synthetisches oder natürliches Polymer verstanden wird, das aus entsprechenden Monomeren hergestellt ist.

Die Verbundfolie des Rückseitenfolienmaterials 5 kann neben der Faserverstärkung 10 und der (ersten) Kunststoffschicht 9 zumindest eine zweite Kunststoffschicht 11 aufweisen, wobei die zweite Kunststoffschicht weniger bzw. nicht stabilisiert ist. Dabei ist - bezogen auf die Einbaulage - die weniger bzw. unstabilisierte zweite Kunststoffschicht 11 insbesondere direkt über der (höher) stabilisierten ersten Kunststoffschicht 9 angeordnet. Die weniger bzw. unstabilisierte zweite Kunststoffschicht 11 ist also nicht direkt der Bewetterung ausgesetzt. Bevorzugt weist die weniger bzw. unstabilisierte zweite Kunststoffschicht 11 eine höhere Schichtdicke auf als die erste Kunststoffschicht 9.

Die Kunststoffschicht 11 kann beispielsweise zu zumindest 80 Gew.-%, insbesondere zu zumindest 90 Gew.-%, vorzugsweise zu 100 Gew.-% aus einem Kunststoff bestehen, der ausgewählt ist aus einer Gruppe umfassend oder bestehend aus Polyolefinen, Kunststoffen auf Basis von beispielsweise Polyestern oder Polyamiden.

Generell kann das Rückseitenfolienmaterial aus mehreren Einzelschichten bestehen, die untereinander über Klebstoffe verbunden werden. Hierzu eignen sich einerseits 2 Komponenten Klebstoffsysteme auf Polyurethanbasis oder auch Heißklebesysteme. Neben Klebstoffen kann auch die Coextrusion und die Extrusionsbeschichtung als Verbindungsmöglichkeit eingesetzt werden. Selbstverständlich ist auch eine Kombination möglich, dass mehrere Kunststoffe coextrudiert und mit einer extrusionsbeschichteten Metall- oder Faserverstärkungsschicht miteinander klebekaschiert werden.

Es sei bereits an dieser Stelle erwähnt, dass auch die einzelnen Schichten des Einbettelementes 3 über die genannten Verbindungsmethoden miteinander verbunden sein können. Gemäß einer weiteren Ausführungsvariante ist vorgesehen, dass die Verbundfolie des Rückseitenfolienmaterials 5 zumindest eine Barriereschicht 12 enthält, wie dies in Fig. 1 strichliert dargestellt ist. Diese Barriereschicht 12 ist durch zumindest eine Metallfolie, insbesondere eine Aluminiumfolie, gebildet. Es sind aber auch andere Barriereschichtmaterialien, wie beispielsweise Kupfer, möglich.

Die Barriereschicht 12 ist bevorzugt zwischen der Faserverstärkung 10 und der Kunststoffsicht 9 angeordnet, kann aber auch unterhalb der ersten Kunststoff-schicht 9 oder der zweiten Kunststoffschicht 11 oder zwischen der ersten und der zweiten Kunststoffschicht 9,11 angeordnet sein. Gegebenenfalls können auch mehrere Barriereschichten 12 in Rückseitenfolienmaterial 5 vorgesehen bzw. angeordnet sein. Diese mehreren Barriereschichten 12 können insbesondere voneinander beabstandet in Rückseitenfolienmaterial 5 angeordnet sein.

Die Barriereschicht(en) 12 bildet insbesondere eine Barriere gegen in das Photovoltaikelement 1 von außen eindringenden Wasserdampf.

Wie bereits voranstehend ausgeführt, weist das Photovoltaikelement 1 ein Einbettelement 3 mit den beiden Einbettfolienmaterialien 7, 8 auf. Die beiden Einbettfolienmaterialien 7, 8 können ein- oder mehrschichtig aufgebaut sein, wobei die jeweils einschichtige Ausführung des Einbettfolienmaterials 7 und des Einbettfolienmaterials 8 bevorzugt wird.

Vorzugsweise besteht zumindest eines der beiden Einbettfolienmaterialien 7, 8, bevorzugt beide, aus einem physikalisch vernetzten Kunststoff. Es wird diese also kein chemisches Vernetzungsmittel zugesetzt, sodass der fertige Kunststoff im Photovoltaikelement 1 auch frei ist von derartigen chemischen Vernetzungsmitteln oder Spaltprodukten davon.

Die physikalische Vernetzung erfolgt bevorzugt über ionische Bindungen im Ionomer, wobei Zn2+ als Kation und die Carboxylgruppe der Hauptkette als Anion wirkt.

Nach einer weiteren Ausführungsvariante des Photovoltaikelementes 1 kann auch das Rückseitenfolienmaterial 5 zumindest eine Schicht aus einem physikalisch vernetzten Kunststoff aufweisen, beispielsweise die Kunststoffschicht 9 und/oder die zweite Kunststoffschicht 11.

Als physikalisch vernetzter Kunststoff können beispielsweise Ionomere, Vinyl-Copolymere, wie z.B. Polyvinylbutyral, oder thermoplastische Elastomere eingesetzt werden.

In der bevorzugten Ausführungsvariante ist dieser physikalisch vernetzte Kunststoff des Einbettfolienmaterials 7 und/oder 8 und/oder des Rückseitenfolienmaterials 5 ein Ionomer. Das Einbettfolienmaterial 7 und/oder 8 und/oder das Rückseitenfolienmaterial 5 kann zu zumindest 80 Gew.-%, insbesondere zu zumindest 90 Gew.-%, bevorzugt ausschließlich aus dem Ionomer bestehen. Es ist dabei auch möglich, dass das Photovoltaikelement 1 mehr als eine Schicht aus einem Ionomer aufweist. Beispielsweise kann das obere Einbettfolienmaterial 7 aus einem anderen Ionomer bestehen als das untere Einbettfolienmaterial 8.

Das Ionomer des Einbettfolienmaterials 7 und/oder 8 und/oder des Rückseitenfolienmaterials 5 kann ausgewählt sein aus einer Gruppe umfassend bzw. bestehend aus ionomeren (Co)polymeren aus Ethylen und einer α,β-ungesättigten Carbonsäure oder einem Carbonsäureanhydrid dieser Carbonsäure, insbesondere (Co)polymeren von Ethylen und Methacrylsäure.

Vorzugsweise enthält das Ionomer Carbonsäuregruppen, die mit Metallionen ausgewählt aus der Gruppe Natrium, Kalium, Calcium, Magnesium, Zink zumindest teilweise neutralisiert sind.

Besonders bevorzugt ist das Ionomer ein Zink-Ionomer auf Basis Ethylen/ Methacrylsäure-Copolymer, welches durch Copolymerisation von Ethylen mit polaren Acrylmonomeren hergestellt wird. Im Vergleich zu anderen Ionomeren kann damit die Haftung zu Glasoberflächen oder Polyamid verbessert werden. Andererseits weist dieses Ionomer aber auch gute Fließeigenschaften, eine hohe Schlagzähigkeit und eine geringe Feuchtigkeitsaufnahme auf.

Es sei jedoch darauf hingewiesen, dass prinzipiell auch Polymere eingesetzt werden können, die sich durch entsprechende Anregung erweichen lassen und durch die Erwärmung oder nach anschließender Abkühlung dreidimensional vernetzen.

Bevorzugt werden solche Polymere, die Anregung durch thermische Anregung möglich ist, da sich dann die physikalische Vernetzung besser in den Laminationsprozess zur Herstellung des Photovoltaikelementes 1 einbinden lässt, insbesondere kein zusätzlicher Verarbeitungsschritt zur Herstellung des vernetzten Kunststoffes erforderlich ist.

Bezüglich des Laminationsverfahrens an sich sei auf den einschlägigen Stand der Technik verwiesen.

Ein möglicher Schichtaufbau für das Photovoltaikelement 1 besteht an der Außenseite (Kunststoffschicht 11) aus PET (Polyethylenterephthalat), welches gegebenenfalls mit Titandioxid zur besseren Witterungsbeständigkeit und zur Reflexion von außen ausgerüstet ist. Weiter kann diese Schicht auch mit Flamm-schutzmittel zur besseren Flammwidrigkeit ausgerüstet sein. Neben PET kann diese Schicht auch aus Fluorpolymeren, Polyamiden oder Polyolefinen bestehen. Auf dieser und in Richtung auf die Photovoltaikzellen 4 ist mit einer Klebe-schicht oder auch über Coextrusion direkt eine zweite PET Schicht (Kunststoff-schicht 11) zur Isolierung und ohne bzw. mit geringerer Stabilisierung angeordnet.

Eine weitere über Klebstoff oder Extrusionsbeschichtung verbundene Schicht ist eine Metallfolienschicht (Barriereschicht 12), insbesondere eine Aluminiumfolienschicht zur besseren Barriere der Folie und zur Reflexion eventuell neben der Photovoltaikzellen 4 vorbeigehenden Sonnenstrahlung zurück auf die Photovoltaikzellen 4, um auch diese Energie zu nutzen. Die Metallfolienschicht kann auch entfallen.

Als nächste Schicht ist entweder auf die Metallfolie oder auf dem PET mit Klebstoff oder über Extrusionsbeschichtung die Faserverstärkungsschicht eingebracht. Den Abschluss nach innen kann gegebenenfalls eine zusätzlich, mittels Klebstoff oder Extrusionsbeschichtung verbundene, Ionomer-, EVA-, Polyvinylbutyral- oder Polyolefin- Schicht sein, welche als Einbettmaterial für die Zellen fungiert.

Ein zusätzliches Fasergewebe kann auch zwischen den beiden PET, bzw. einer PET und einer PVF Schichten eingebracht sein.

Dadurch wird ein steifer Folienaufbau geschaffen, der bevorzugt als Rückseitenfolienmaterial 5 bei Photovoltaikelementen 1 eingesetzt wird. Durch die verbesserten thermomechanischen Eigenschaften des Rückseitenfolienmaterials 5 und das verbesserte Barriereverhalten kann das Rückseitenfolienmaterial 5 auch als Rückseitenfolie für flexible Photovoltaikelemente 5 eingesetzt werden. Dabei kann insbesondere eine Verbesserung des Laminationsverhaltens- bzw. der Laminatqualität erreicht werden.

Nach einer Ausführungsvariante kann das Rückseitenfolienmaterial 5 bereits mit dem unteren Einbettfolienmaterial 8 ausgerüstet sein. Damit wird der Zusammenbau vereinfacht, da im (Laminations)Prozess zur Herstellung des Photovoltaikelementes eine Schicht weniger aufgebracht werden muss und sich somit die Montagezeit, aber auch die Fehlermöglichkeit reduziert werden kann.

Zur Evaluierung der Werkstoffe wurden verschiedene Tests durchgeführt und mit Stand der Technik Werkstoffen, die in derartigen Photovoltaikelementen 1 eingesetzt werden, verglichen.

So ist in Fig. 2 der Brechungsindex n_{D} (Ordinate) eines Einbettungsfolienmaterials 7, 8 aus einem Zink-Ionomer auf Basis Ethylen/ Methacrylsäure-Copolymer (obere Kurve) im Vergleich zu EVA (untere Kurve) in Abhängigkeit von der Temperatur (Abszisse, [°C]) dargestellt. Die Messung erfolgte bei einer Wellenlänge von 589,3 nm und Temperaturen von 10 °C bis 70°C.

Wie aus dieser Fig. 2 ersichtlich ist, weist EVA in Hinblick auf Solarglas, das einen Brechungsindex von ca. 1,49 bei Raumtemperatur aufweist, über den betrachteten Temperaturbereich einen geringeren Brechungsindex auf. Das Einbettungsfolienmaterials 7, 8 aus dem Zink-Ionomer hat demgegenüber und gegenüber Solarglas einen deutlich höheren Brechungsindex auf. Dies wirkt sich günstig in Hinblick auf die voranstehend genannte Rückreflexion aus.

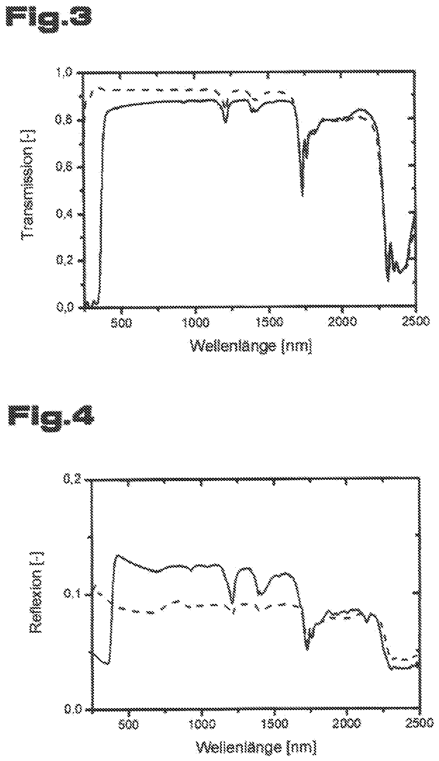

In den Fig. 3 und 4 ist das Transmissionsspektrum bzw. Reflexionsspektrum des Einbettungsfolienmaterials 7, 8 (Wellenlänge auf der Abszisse aufgetragen) aus diesem Ionomer dargestellt. Die Messung erfolgte mittels UV-VIS-NIR-Spektrometer mit 150 mm Ulbricht-Kugel. Die gerichtet-hemisphärischen Transmissions- (T) und Reflexionsgrade (R) wurden im Wellenlängenbereich von 250 nm bis 2500 nm aufgezeichnet. Die Gewichtung der Spektren erfolgte mit dem terrestrischen Solarspektrum AM1,5 im Integrationsbereich von 400 nm bis 1100 nm.

Im für Photovoltaikelemente 1 relevanten Wellenlängenbereich von 400 nm bis 1100 nm weist das Ionomer (obere Kurve in Fig. 3 und untere Kurve in Fig. 4) eine Lichttransmission T von ca. 90,9 % und eine Lichtreflexion R von ca. 8,7 % auf, wohingegen EVA (untere Kurve in Fig. 3 und obere Kurve in Fig. 4) eine Lichttransmission T von ca. 85,8 % und eine Lichtreflexion R von ca. 12,4 % auf-weist. Die Lichtabsorption (= 1 - T. - R) des Ionomers beträgt somit nur 0,4 % während jene von EVA 1,8 % beträgt.

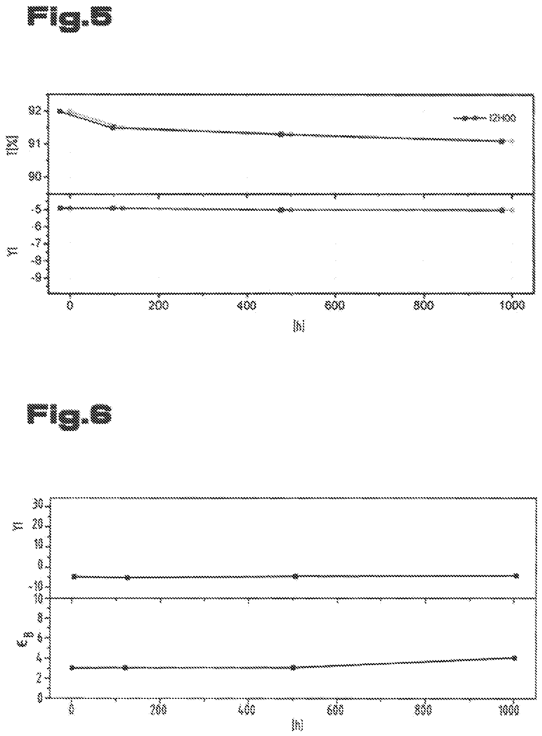

Zur Bestimmung des Alterungsverhaltens wurde ein Einbettfolienmaterial 7 aus dem Ionomer einer UV-Strahlung (Q-Sun Xe-1) ausgesetzt (ISO 4892-2:2013). Die entsprechend gemessenen Werte sind in Fig. 5 wiedergegeben. Auf der Abszisse ist dabei die Zeit in Stunden aufgetragen, in denen das Einbettfolien-material 7 der UV-Bestrahlung ausgesetzt war, während auf der Ordinate im unteren Bildteil YI (YI = Yellowness Index nach ASTM D1925-70:1988) und im oberen Bildteil T in Prozent (Transmissionsgrad) dargestellt sind.

Wie aus Fig. 5 ersichtlich ist, nimmt das Transmissionsverhalten des Einbettfolienmaterials 7 über die Nutzungsdauer kaum ab.

In Fig. 6 sind die entsprechenden Werte für das Rückseitenfolienmaterial 5 wiedergegeben. Es wurde eine Glasgewebe/Aluminium/PET-Hybridfolie als Rückseitenfolienmaterial 5 eingesetzt. Gemessen wurde der Yellowness Index (YI) nach ASTM D1925-70 bzw. die Bruchdehnung nach ISO 527. Auf der Abszisse der Fig. 6 ist wiederum die Zeit in Stunden, in denen das Rückseitenfolienmaterial der UV-Bestrahlung ausgesetzt war, aufgetragen. Die Ordinate zeigt im unteren Bildteil die Bruchdehnung ε in Prozent, und im oberen Bildteil den Yellowness Index.

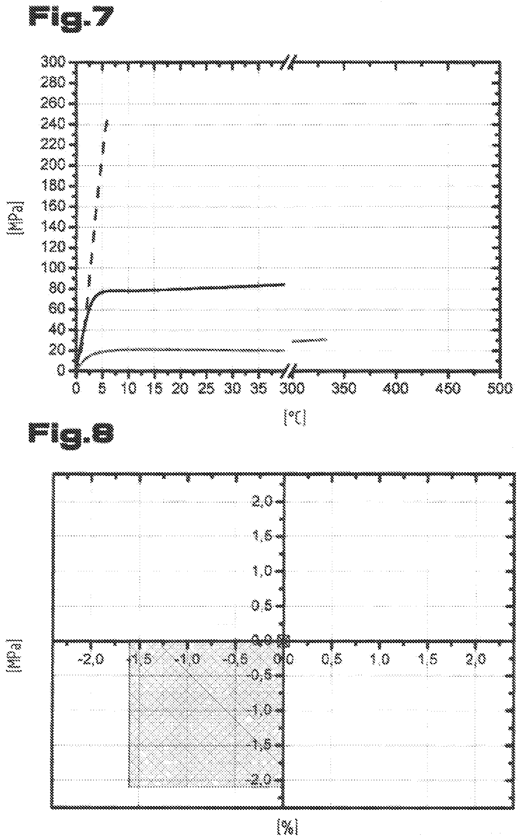

Schließlich sind in den Fig. 7 und 8 das Dehnungsverhalten (in Fig. 7 Abszisse in Prozent) des Rückseitenfolienmaterials 5 unter Spannung (in Fig. 7 Ordinate [MPa]) und dessen Schrumpfverhalten (Ordinate in Fig. 8: Schrumpf in Längsrichtung; Abszisse in Fig. 8: Schrumpf in Querrichtung; jeweils in Prozent) dargestellt. Gemessen wurde nach ISO 527 bzw. der Schrumpf wurde nach zwei Stunden bei 150 °C anhand von 100 x 100 mm² Folienmustern beurteilt.

Dabei zeigt die Fig. 7 das Spannungs-Dehnungsverhalten des Ionomers (oberste Linie) im Vergleich zu ICOSOLAR® 2442 (mittlere Linie) und ICOSOLAR® AAA 3554 (unterste Linie). Es ist deutlich zu ersehen, dass das Rückseitenfolienmate-rial 5 nach der Erfindung höhere Spannungen aufnehmen kann, als herkömmliche, in Photovoltaikelementen 1 verwendete Werkstoffe hierfür.

Aus Fig. 8 ist wiederum ersichtlich, dass das Rückseitenfolienmaterial 5 nach der Erfindung (Punkt mit den Koordinaten [0, 0]) im Vergleich zu herkömmlich verwendeten Werkstoffen (schraffierte Fläche) keinen (wesentlichen) Schrumpf in Quer- bzw. Längsrichtung aufweist. Der vernachlässigbare Schrumpf im Vergleich zu üblicherweise eingesetzten Kunststoff-Rückseitenfolien zeichnet das Rückseitenfolienmaterial 5 gemäß der Erfindung aus. Dadurch ergeben sich deutliche Vorteile beim Handling und der Lamination der PV-Module.

Die Ausführungsbeispiele zeigen bzw. beschreiben mögliche Ausführungsvarianten des Photovoltaikelementes 1, wobei an dieser Stelle bemerkt sei, dass auch diverse Kombinationen der einzelnen Ausführungsvarianten untereinander möglich sind.

Der Ordnung halber sei abschließend darauf hingewiesen, dass zum besseren Verständnis des Aufbaus des Photovoltaikelementes 1 dieses bzw. dessen Bestandteile teilweise unmaßstäblich und/oder vergrößert und/oder verkleinert dargestellt wurden.

### Bezugszeichenaufstellung

1 Photovoltaikelement
2 Abdeckelement
3 Einbettelement
4 Photovoltaikzelle
5 Rückseitenfolienmaterial
6 Rahmen
7 Einbettfolienmaterial
8 Einbettfolienmaterial
9 Kunststoffschicht
10 Faserverstärkung
11 Kunststoffschicht
12 Barriereschicht

## Patentansprüche

1. Photovoltaikelement (1) umfassend eine oberes Einbettfolienmaterial (7) und eine unteres Einbettfolienmaterial (8), wobei zwischen dem oberen und dem unteren Einbettfolienmaterial (7, 8) Photovoltaikzellen (4) eingebettet sind, sowie ein Rückseitenfolienmaterial (5), das in Einbaulage des Photovoltaikelementes (1) unterhalb des unteren Einbettfolienmaterials (8) angeordnet ist, wobei das Rückseitenfolienmaterial (5) durch eine Verbundfolie gebildet ist, die zumindest eine Kunststoffschicht (9) und zumindest eine Faserverstärkung (10) umfasst **dadurch gekennzeichnet, dass** die Verbundfolie des Rückseitenfolienmaterials (5) zumindest eine Barriereschicht (12) enthält, die durch zumindest eine Metallfolie gebildet ist.

2. Photovoltaikelement (1) nach Anspruch 1, **dadurch gekennzeichnet, dass** die Verbundfolie des Rückseitenfolienmaterials (5) zumindest eine erste, außenliegende Kunststoffschicht (9) und zumindest eine zweite, innenliegende Kunststoffschicht (11) aufweist, wobei die zweite, innenliegende Kunststoffschicht (11) weniger stabilisiert ist als die erste, außenliegende Kunststoffschicht (9).

3. Photovoltaikelement (1) nach Anspruch 1 oder 2, **dadurch gekennzeichnet, dass** die Barriereschicht (12) durch eine Aluminiumfolie gebildet ist.

4. Photovoltaikelement (1) nach einem der Ansprüche 1 bis 3, **dadurch gekennzeichnet, dass** die Verbundfolie des Rückseitenfolienmaterials (5) eine Schicht aus einem physikalisch vernetzten Kunststoff aufweist.

5. Photovoltaikelement (1) nach einem der Ansprüche 1 bis 4, **dadurch gekennzeichnet, dass** der physikalisch vernetzte Kunststoff des Einbettfolienmaterials (7, 8) ein Ionomer ist.

6. Photovoltaikelement (1) nach Anspruch 4 oder 5, **dadurch gekennzeichnet, dass** der physikalisch vernetzte Kunststoff des Rückseitenfolienmaterials (5) ein Ionomer ist.

7. Photovoltaikelement (1) nach Anspruch 6 oder 7, **dadurch gekennzeichnet, dass** das Ionomer ein Zink-Ionomer auf Basis Ethylen/ Metacrylsäure-Copolymer ist.

8. Photovoltaikelement (1) nach einem der Ansprüche 1 bis 7, **dadurch gekennzeichnet, dass** jeweils die einzelnen Schichten des Einbettfolienmaterials (7, 8) und/oder des Rückseitenfolienmaterials (5) mit einem Klebstoff miteinander verbunden sind.

9. Photovoltaikelement (1) nach einem der Ansprüche 1 bis 8, **dadurch gekennzeichnet, dass** die Faserverstärkung (10) zu zumindest 80 Gew.-% aus Glasfasern besteht.

10. Photovoltaikelement (1) nach einem der Ansprüche 1 bis 9, **dadurch gekennzeichnet, dass** die Faserverstärkung (10) durch ein Gewebe gebildet ist.

11. Photovoltaikelement (1) nach einem der Ansprüche 1 bis 10, **dadurch gekennzeichnet, dass** eine aus der Faserverstärkung (10) bestehende Schicht ein Flächengewicht zwischen 100 g/m² und 250 g/m² aufweist

12. Photovoltaikelement (1) nach einem der Ansprüche 1 bis 11, **dadurch gekennzeichnet, dass** zumindest eines der beiden Einbettfolienmaterialien (7, 8) einen physikalisch vernetzten Kunststoff aufweist.

## Claims

1. A photovoltaic element (1) comprising an upper embedding film material (7) and a lower embedding film material (8), wherein photovoltaic cells (4) are embedded between the upper and the lower embedding film materials (7, 8), and comprising a back-side film material (5), which is arranged below the lower embedding film material (8) in the installation position of the photovoltaic element (1), wherein the back-side film material (5) is formed by a composite film, which comprises at least one plastic layer (9) and at least one fiber reinforcement (10), **characterized in that** the composite film of the back-side film material (5) contains at least one barrier layer (12) formed by at least one metal film.

2. The photovoltaic element (1) according to claim 1, **characterized in that** the composite film of the back-side film material (5) comprises at least one first, outer plastic layer (9) and at least one second, inner plastic layer (11), wherein the second, inner plastic layer (11) is less stabilized than the first, outer plastic layer (9).

3. The photovoltaic element (1) according to claim 1 or 2, **characterized in that** the barrier layer (12) is formed by an aluminum film.

4. The photovoltaic element (1) according to one of claims 1 to 3, **characterized in that** the composite film of the back-side film material (5) comprises a layer of a physically cross-linked plastic material.

5. The photovoltaic element (1) according to one of claims 1 to 4, **characterized in that** the physically cross-linked plastic material of the embedding film material (7, 8) is an ionomer.

6. The photovoltaic element (1) according claims 4 or 5, **characterized in that** the physically cross-linked plastic material of the back-side film material (5) is an ionomer.

7. The photovoltaic element (1) according to claim 6 or 7, **characterized in that** the ionomer is a zinc ionomer based on ethylene/metacrylic acid copolymer.

8. The photovoltaic element (1) according to one of claims 1 to 7, **characterized in that** each of the individual layers of the embedding film material (7, 8) and/or of the back-side film material (5) are connected to one another by means of an adhesive.

9. The photovoltaic element (1) according to one of claims 1 to 8, **characterized in that** the fiber reinforcement (10) consists of glass fibers to at least 80 wt.%.

10. The photovoltaic element (1) according to claim 1 to 9, **characterized in that** the fiber reinforcement (10) is formed by a woven fabric.

11. The photovoltaic element (1) according to one of claims 1 to 10, **characterized in that** a layer consisting of the fiber reinforcement (10) has a mass per unit area of between 100 g/m² and 250 g/m².

12. The photovoltaic element (1) according to one of claims 1 to 11, **characterized in that** at least one of the two embedding film materials (7, 8) comprises a physically cross-linked plastic material.

## Revendications

1. Élément photovoltaïque (1) comprenant un film d'insertion supérieur (7) un film d'insertion inférieur (8), moyennant quoi, entre les films d'insertion supérieur et inférieur (7, 8), sont intégrées des cellules photovoltaïques (4), ainsi qu'un film arrière (5) qui, lorsque l'élément photovoltaïque (1) est monté, est disposé en dessous du film d'insertion inférieur (8), le film arrière (5) étant constitué d'un film composite qui comprend au moins une couche de matière plastique (9) et au moins un renforcement par des fibres (10), **caractérisé en ce que** e film composite du film arrière (5) contient au moins une couche de barrière (12) qui est constituée d'au moins un film métallique.

2. Élément photovoltaïque (1) selon la revendication 1, **caractérisé en ce que** le film composite du film arrière (5) comprend au moins une première couche de matière plastique externe (9) et au moins une deuxième couche de matière plastique interne (11), la deuxième couche de matière plastique interne (11) étant moins stabilisée que la première couche de matière plastique externe (9).

3. Élément photovoltaïque (1) selon la revendication 1 ou 2, **caractérisé en ce que** la couche de barrière (12) est constituée d'un film d'aluminium.

4. Élément photovoltaïque (1) selon l'une des revendications 1 à 3, **caractérisé en ce que** le film composite du film arrière (5) comprend une couche constituée d'une matière plastique physiquement réticulée.

5. Élément photovoltaïque (1) selon l'une des revendications 1 à 4, **caractérisé en ce que** la matière plastique physiquement réticulée du film d'insertion (7, 8) est un ionomère.

6. Élément photovoltaïque (1) selon la revendication 4 ou 5, **caractérisé en ce que** la matière plastique physiquement réticulée du film arrière (5) est un ionomère.

7. Élément photovoltaïque (1) selon la revendication 6 ou 7, **caractérisé en ce que** l'ionomère est un ionomère de type zinc à base d'un copolymère éthylène/acide métacrylique.

8. Élément photovoltaïque (1) selon l'une des revendications 1 à 7, **caractérisé en ce que** les différentes couches du film d'insertion (7, 8) et/ou du film arrière (5) sont reliées entre elles par une colle.

9. Élément photovoltaïque (1) selon l'une des revendications 1 à 8, **caractérisé en ce que** le renforcement de fibres (10) est constitué d'au 80 % en poids de verre.

10. Élément photovoltaïque (1) selon l'une des revendications 1 à 9, **caractérisé en ce que** le renforcement de fibres (10) est constitué d'un tissu.

11. Élément photovoltaïque (1) selon l'une des revendications 1 à 10, **caractérisé en ce qu'**une couche constituée du renforcement de fibres (10) présente un poids surfacique entre 100 g/m² et 250 g/m².

12. Élément photovoltaïque (1) selon l'une des revendications 1 à 11, **caractérisé en ce qu'**au moins un des deux films d'insertion (7, 8) contient une matière plastique physiquement réticulée.
